# EUROPEAN PATENT SPECIFICATION

(11) **EP 1 979 505 B1**
(45) Date of publication and mention of the grant of the patent: **19.05.2010**
(21) Application number: 07703133.4
(22) Date of filing: 30.01.2007
(51) Int. Cl.: C23C 28/04

(54) **THIN-FILM MULTILAYER STRUCTURE, COMPONENT COMPRISING SAID STRUCTURE AND ITS METHOD OF DEPOSITION**
MEHRSCHICHTIGE DÜNNFILMSTRUKTUR, KOMPONENTE MIT DIESER STRUKTUR UND VERFAHREN ZU IHRER ABLAGERUNG
STRUCTURE MULTICOUCHE EN FILMS FINS, COMPOSANT COMPRENANT LADITE STRUCTURE ET SA MÉTHODE DE DÉPÔT

(30) Priority: 30.01.2006 FR 0600829
(43) Date of publication of application: 15.10.2008
(73) Proprietor: European Aeronautic Defence and Space Company EADS France, 75016 Paris (FR)
(72) Inventor: LUCAS, Valérie, F-78670 Villennes Sur Seine (FR); JOINET, Mickael, 92310 Sevres (FR); TEYSSANDIER, Francis, 66330 Cabestany (FR); THOMAS, Laurent, 66240 Saint-Esteve (FR)
(74) Representative: Dossmann, Gérard
(86) International application number: PCT/EP2007/000779
(87) International publication number: WO 2007/085494

(56) References cited:
- WO-A-2004/113586
- FR-A- 2 736 361
- US-A- 5 522 343

## Description

The present invention relates to a corrosion-resistant thin-film multilayer structure having a low wear rate and a low coefficient of friction, to a component comprising said structure and to its method of deposition.

For some ten years, hard films with a low wear rate, more particularly those with a low wear rate and a low coefficient of friction, have offered considerable advantages in many thermomechanical fields of application, such as cutting tools, mechanical components, rolling members and gears. For example, there is currently a growing interest in producing such films on metal alloys, such as titanium alloys for the aeronautical or aerospace industry.

The thin films are generally produced by PVD (physical vapour deposition). In particular, when the thin films are intended to be subjected to frictional wear, they may be based on a nitride and/or a carbide, for example TiN, TiCN, TiCrN, CrC or TiAlN, and are produced by PVD on a titanium-based substrate, or they may be of the adamantine carbon or DLC (diamond-like carbon) type, that is to say of the type consisting of hydrogenated or unhydrogenated amorphous carbon, which are produced by PACVD (plasma-assisted chemical vapour deposition).

The term DLC covers a wide variety of lightly or highly hydrogenated materials. They are customarily used in applications requiring a high hardness and a high elastic modulus, for example 15-30 GPa and 200-280 GPa respectively. This gives them, under the conditions of use, low coefficients of friction (µ) and limited wear rates of the order of 10⁻⁶-10⁻⁷ mm³.N.m⁻¹. The coefficient of friction is less than 0.2, especially with respect to steels, aluminium alloys and titanium alloys. For the latter two alloy, such a low level of friction is exceptional. The demand for this type of coating in the engineering industry is therefore becoming greater and greater as one of the main properties of DLC coatings is abrasive wear resistance, which is much higher than for nitride-type materials of equivalent hardness, owing to their high elastic modulus.

However, they have the drawback of limited corrosion resistance:
(i) in a dry medium, DLCs oxidize above 400°C, resulting in degradation (graphitization) above about 400°C; and
(ii) in a wet medium, growth defects induce pitting corrosion.

In addition, DLCs are highly strained, which requires complex sublayers for matching the strain or elastic modulus profiles between the coated component and the upper layer. The presence of these accommodating layers or sublayers, which have various thicknesses ranging up to a few microns, makes it difficult to predict the mechanical properties associated with the adhesion of the films to the substrates, the mechanical strength under load, the physico-chemical interaction of the various superposed materials, and the thermal resistance of the whole assembly. These multilayer systems induce an additional degree of difficulty as regards optimizing the behaviour of the coating for the desired function.

Patent Application FR 2 736 361 describes a thin film containing carbon, silicon and hydrogen, the latter element being present in an amount of less than 30 at% and the C/Si ratio being between about 1.4 and about 3.3. This film is produced by PACVD and has a low coefficient of friction.
however, the coatings of the prior art do not satisfy the industrial requirements of coatings for tribological purposes (limiting the wear and friction, as explained in the prior art) on metal substrates.

There is therefore a need for a coating having, simultaneously:
tribological properties, such as a low wear rate and a low coefficient of friction when dry (i.e. without the addition of a lubricant moreover) with respect to metal surfaces in a corrosive atmosphere and/or at high temperature;
- adhesion properties, such as a high mechanical strength of the coating on metal substrates; and
- a high resistance of the coatings at high temperature, for example above 400°C, without modifying the tribological properties of the coatings and adhesion to their substrates.

The Applicant has found, surprisingly, that one particular multilayer structure provides such a combination of properties by associating several layers based on silicon, carbon and hydrogen, with a thickness ranging from 5 nm to 5 µm, which have different tribological properties, at least two layers forming a period, each period being repeated n times where n ranges from 1 to 1000.

One subject of the invention is therefore the corrosion-resistant thin-film multilayer structure having a low wear rate and a low coefficient of friction defined in claim 1.

The expression "low coefficient of friction" is understood within the present invention to mean a coefficient of friction µ of less than 0.2, for example:
- under the conditions for tribological tests carried out using a rotary tribometer, under an applied normal load of 3 N, for a travel distance of 100 m and a speed of displacement of 0.02 m.s⁻¹, running dry, i.e. without addition of lubricant moreover, in a 25°C ambient laboratory atmosphere, and with an opposing metal body consisting of a ball 6 mm in diameter made of 100C6 steel; and
- under reciprocating friction test conditions, with a to-and-fro movement, under an applied normal load of 3 N, for a travel distance of 20 m and a speed of displacement of 0.00017 m.s⁻¹, running dry, that is to say without the addition of lubricant moreover, in a 25°C ambient laboratory atmosphere, and with an opposing metal body consisting of a ball 6 mm in diameter made of 100C6 steel.

A low coefficient of friction makes it possible to envisage using said structure in many industrial fields, whenever contacting components are required to move one relative to the other, either continuously or intermittently.

The expression "low wear rate" is understood within the context of the present invention to mean a wear rate of less than 10⁻⁵ mm³.N.m⁻¹ measured under the tribological test conditions described above, by profilometry of the wear tracks after rubbing the films.

The term "corrosion resistance" is understood within the present invention to mean a dissolution potential that reaches the dissolution potential of the substrate after 100 hours, measured electrochemically in an aqueous 5% NaCl solution at a pH of 5.5 at a temperature of 25°C, with a saturated calomel reference electrode.

The multilayer structure preferably has a total thickness of 10 µm or less, preferably from 1 to 6 µm.

Each layer in the period consists of carbon, silicon and hydrogen, the Si/C atomic ratio ranging in particular from 0.3 to 1.5. The proportion of hydrogen preferably varies from 10 to 30 at%.

The thickness of each layer in the period is preferably within the range from 5 nm to 5 µm, better still from 10 mm to 1 µm and even more preferably from 10 nm to 500 nm.

Each layer has, independently of one another in a period, specific mechanical properties, which are the same or different, such as a hardness of 1 to 100 GPa, preferably 5 to 80 GPa, and a Young's elastic modulus of 10 to 600 GPa, preferably 80 to 400 GPA. These physical properties are measured by the nanoindentation technique, with a Berkovich indenter and under loads between 0.5 mN and 200 mN, allowing penetration depths of 10 nm to 1.5 µm to be achieved.

The adhesion properties are measured by the scratch resistance test. The test conditions are the following: a Rockwell diamond stylus of spherical geometry with a radius of 200 µm is applied to the surface of the thin film with a gradually increasing normal load varying from 0 to 30 N with a constant speed of 5 mm/min over a distance of 5 mm. Good adhesion corresponds to a critical load (Lc2) of greater than 15 N, preferably greater than 20 N.

The term "functional layer" is understood within the context of the present invention to mean a layer exhibiting remarkable corrosion resistance properties, scratch resistance properties or tribological properties such as, for example, a low coefficient of friction and a low wear rate.

The optional functional surface layer imparts properties different from those of the layers of the periods lying beneath it.

The functional layer essentially comprises carbon, i.e. 30 to 100 at%, preferably 40 to 90 at%, carbon. It may also comprise additional elements such as silicon, hydrogen, sulphur, fluorine, titanium or tungsten, these additional elements being preferably present in a proportion of 0 to 70 at%, better still 10 to 60 at%.

The thickness of the latter layer preferably does not exceed 3 µm and more particularly lies in the range from 1 nm to 2 µm.

This functional surface layer also has mechanical properties such as a hardness of 1 to 100 GPa, preferably 5 to 80 GPa, and a Young' s modulus of 10 to 600 GPa, preferably 80 to 400 GPa.

The subject of the invention is also a corrosion-resistant component having a low wear rate and a low coefficient of friction, comprising:
- a metal substrate made of a material that is not impaired when it is heated to a temperature below 600 °C, preferably in a range from 200 to 600°C;
- a tie layer; and
- a surface coating covering said tie layer, the surface coating being a thin-film multilayer structure according to the invention as defined above.

The metal substrate is preferably made of titanium or one of its alloys, such as TA6V or Ti10.2.3, high-speed steel, such as steels HS18-0-1 and HS6-5-2-5, stainless steel, or a carbide such as WC + Co K10 and WC + TiC + Ta (Nb) C + Co P 10 K 10.

The tie layer interposed between the substrate and the surface coating is nitrided, carburized, carbonitrided or silicided preferably nitrided. As an example of a nitride, mention may in particular be made of titanium nitride when the substrate is based on titanium.

Said tie layer may be produced from an argon/hydrogen/nitrogen mixture, which also allows the surface of the metal substrate to be functionalized so as in particular to promote adhesion of the multilayer structure to the substrate, while limiting its deformation when subjected to a load. The surface nitrogen concentration is preferably in the range from 20 at% to 80 at%.

The thickness of the tie layer is preferably in the range from 0.1 µm to 100 µm, better still from 0.2 µm to 10 µm.

This component has the advantage of combining the following properties:
- the coatings possess good tribological properties, that is to say without a lubricant, with a low wear rate and a low coefficient of friction with respect to metal surfaces in an ambient and/or corrosive and/or high-temperature atmosphere;
- the coatings exhibit good temperature resistance without their adhesion and tribological properties being modified, for example a low wear rate and a low coefficient of friction, in particular up to 550°C, and are corrosion-resistant;
- the complex architecture, consisting of multilayers, allows the mechanical cracking resistance behaviour of the system to be improved; and
- the optional tie layer, essentially consisting of nitrogen and hydrogen, furthermore allows the surface of the metal substrate to be functionalized, while limiting its deformation when subjected to a load.

The invention also relates to a method of depositing a surface coating in the form of a corrosion-resistant thin-film multilayer structure having a low wear rate and a low coefficient of friction on a metal substrate made of a material that is not impaired when it is heated to a temperature below 600°C, by chemical vapour deposition, activated by a microwave plasma and /or by a low-frequency plasma, comprising the following successive steps:
i) installation of the substrate on a support, in a chamber comprising an introduction/extraction zone (called an airlock) and an active zone that can contain a plasma of maximum density, this installation step being followed by the following surface treatment step:
ii) creation of a primary vacuum inside the chamber followed by a secondary vacuum;
iii) etching of the substrate in the active zone by injecting an etching gas in a primary vacuum, creation of a plasma of this gas in a discharge zone (contained in the active zone) and by separately heating the substrate to a regulated temperature between 200°C and 600°C;
iv) formation of a tie layer as described above by injecting a pre-treatment gas into the active zone of the chamber, so as to substitute the etching gas plasma with a pre-treatment gas plasma, while continuing to heat the substrate at said regulated temperature;
v) formation of the multilayer structure as described above by injecting a reactive gas into the active zone, this reactive gas comprising a single compound having a tetrahedral silicon environment or a silicon-containing mixture, so as to substitute the pre-treatment gas plasma with a reactive gas, while continuing to heat the substrate at said regulated temperature, the various layers being obtained by modifying the power of the microwave generator and/or the frequency and/or the voltage of the low-frequency generator;
vi) optional deposition of the functional surface layer in the active zone, by injecting another reactive gas, so as to substitute the plasma of the gas for producing the multilayer structure with a plasma of the reactive gas, while continuing to heat at said regulated temperature; and
vii) interruption of the reactive gas injection of step v) or step vi) and cooling of the substrate, after a predetermined injection time corresponding to the desired thickness of the functional surface layer, the primary vacuum created inside the chamber corresponding to a pressure of 0.13 to 133.3 Pa (10⁻³ to 1 torr), preferably 0.13 to 66.7 Pa (10⁻³ to 0.5 torr), and better still 0.13 to 13.3 Pa (10⁻³ to 10⁻¹ torr).

The secondary vacuum may be, for instance, around 6.5 × 10⁻² mPa (6.5 × 10⁻⁷ mbar) and allows the atmosphere within the zone to be purified.

The gas injected into the active zone may especially be excited by a discharge coming from a microwave source connected to a microwave generator that works at a frequency of 2.45 GHz or 915 MHz, the power of the generator being set between 0 W and 1500 W, and/or coming from a low-frequency generator, the frequency of which ranges from 50 to 460 kHz and the voltage from 0 to 300 V, and the surface power density of which is of the order of 10 w/cm², in order to obtain a gas plasma.

By modifying the power of the microwave generator and/or especially the voltage of the low-frequency generator, it is possible to obtain layers based on C, Si and H using one and the same reactive gas, having different tribological properties.

The etching gas used in step iii) is advantageously argon, to which hydrogen may be added, and its injection rate while etching the substrate is preferably between 0.1 Sl/h (standard litres per hour) and 10 Sl/h.

The pre-treatment gas used in step iv) contains the element nitrogen and/or the element carbon and/or the element hydrogen and/or the element silicon. Examples of such elements may especially be nitrogen, methane, ethane, acetylene, ethylene, hydrogen, silane and disilane, and mixtures thereof. In a preferred implementation of the method, the pre-treatment gas comprises at most about 20% nitrogen and/or methane and/or silane and/or hydrogen, mixed with argon.

It is important to note that the etching may be carried out and the tie layer may be produced in the chamber used for depositing the coating, practically without interruption.

Advantageously, the reactive gas used in step v) comprises tetramethylsilane (TMS) or tetraethylsilane (TES) by itself or as a mixture, or else a mixture of precursors of hydrocarbons, such as methane, ethane, acetylene or ethylene, and/or of silicon-containing compounds, such as silane or disilane.

The reactive gas of this step v) may furthermore contain argon and/or hydrogen. Its injection rate is preferably less than 2 Sl/h.

Preferred embodiments of the invention will now be described by way of non-limiting illustration, with reference to the example and to the appended drawings in which:
- Figure 1 is a schematic view of one embodiment of a component comprising a multilayer structure according to the invention; and
- Figure 2 is a schematic view of a device, of the PACVD deposition reactor type, for implementing the method according to the invention.

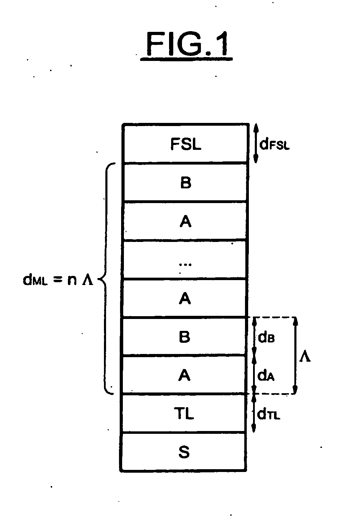

Figure 1 shows a first embodiment of a component according to the invention, comprising:
- a metal substrate S;
- a tie layer TL, having a thickness d_{TL};
- n periods, each period comprising two individual layers A and B with respective thicknesses of d_{A} and d_{B}, the thickness of a period A thus being equal to the sum of the individual thicknesses d_{A} and d_{B}: Λ = d_{A} + d_{B}, and the thickness of the multilayer d_{ML} being equal to nA; and
- a functional surface layer FSL of thickness D_{FSL}, consisting of a hydrogenated carbide, said carbide satisfying for example the formula XC, where X denotes an addition element such as S, Si, W, Ti or F.

The substrate may consist of a titanium alloy, such as the titanium alloy Ta6V.

The intermediate layer TL is for example obtained by nitriding the surface of the substrate S.

The individual layers A and B preferably consist of hydrogenated amorphous silicon carbide, the hydrogenated amorphous silicon carbide of layer A having a lower hardness than that of the hydrogenated amorphous silicon carbide of layer B.

As an example, the functional surface layer consists of an amorphous hydrogenated silicon carbide.

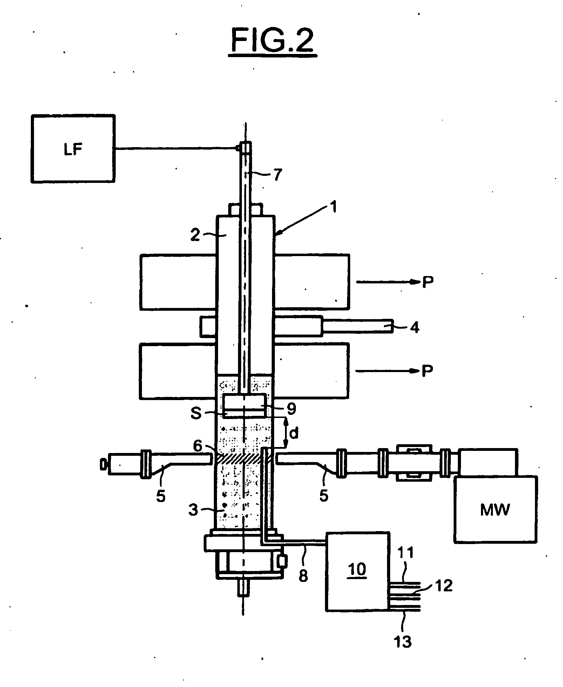

Figure 2 shows a device for obtaining a component according to the invention, such as that shown in particular in Figure 1.

The device comprises a tube reactor 1, of substantially vertical axis. Such a reactor is particularly suitable for manufacturing small components. For more voluminous components, the reactor 1 may have a different geometry.

The reactor 1 is made up of two essential parts, the airlock 2 for loading the specimens and the treatment chamber 3. These parts are separated from each other by a pneumatic slide valve 4 for isolating the chamber 3 when venting the loading airlock 2 for a new load of specimens.

The loading airlock 2 allows the specimens to be introduced and extracted.

A horizontal waveguide 5, for example in the form of a silica tube, passes through the treatment chamber 3 in a region 6 where the 2.45 GHz microwave discharge is created. This waveguide 5 is connected at one of its ends to a microwave generator MW having a power that varies from 0 tao 1500 W.

The waveguide 5 conveys, into the treatment zone 3, in the form of surface waves, the energy needed to create and sustain a stable discharge in the treatment chamber 3.

This stable discharge extends on either side of the zone 6 in which the microwave discharge is created, over a height that depends on a number of parameters, such as the power of the microwave generator MW, the pressure in the treatment chamber, the flow rate of injected gas, etc.

A discharge may also come from the low-frequency generator LF connected to a transfer tube 7, This generator LF makes it possible to apply a range of frequencies from 50 to 400 kHz and a voltage of 0 to 300 V, thereby producing a plasma having other properties.

This discharge also reaches the zone 6 in which the microwave discharge is created.

This or these stable discharges make it possible to sustain a gas plasma, the extent of which is depicted in Figure 2 by a grey zone.

The reactor 1 is equipped with a double pumping system (not shown in Figure 2) so as to regulate the pressure within. This system consists of a two-stage pumping unit, the output of which is around 240 m³/h, making it possible to work with a flux of gas in a primary vacuum during deposition or to pre-evacuate the reactor before switching to a secondary vacuum, and a hybrid turbomolecular unit (250 l/s) (not shown in Figure 2) which provides a secondary vacuum with a limit of about 6.5 × 10⁻² mPa (6.5 × 10⁻⁷ mbar) so as to limit the contamination of the reactor. It also makes it possible to work with a low gas flux for pressures below 10 Pa (0.1 mbar). These two units are connected both to the loading airlock 2 and to the treatment chamber 3 via electropneumatic valves (not shown in Figure 2). These connections are identified by the arrows P.

The total pressure in the reactor is controlled during the deposition by a throttling valve coupled to a capacitance gauge.

The motor-operated transfer tube 7 passes right through the entire device, thus making it possible to vary the distance d between the precursor injection pipe 8 and the substrate holder 9. The residence time of the species incident on the substrate is defined by the choice of distance d. The substrate may be independently heated up to 600°C and is connected, via a tuning box, to the low-frequence generator LF by a capacitive coupling.

In addition to the various component parts that have just been described, the device illustrated in Figure 2 includes means for injecting various gases into the reactor 1 that are needed for implementing the method and especially for forming the desired thin-film multilayer structure on the substrate S.

In the embodiment shown, these gas injection means mainly comprise an injection pipe 8 that passes through the bottom of the reactor 1 and runs along the vertical axis of said pipe before emerging in a second region of the treatment chamber 3 located between the substrate S and the zone 6 in which the microwave discharge is created, or in an adjacent part of the zone 6 facing the substrate S. Outside the reactor 1, the pipe 8 is connected to a flowmeter system 10 for regulating at will the flow rate of the injected gases. This flowmeter system 10 is itself connected to an etching gas feed pipe 11, to a pre-treatment gas feed pipe 12 and to a reactive gas or precursor gas feed pipe 13.

In an alternative embodiment, the flowmeter system 10 may be provided with six independent gas lines.

The etching gas fed via the pipe 11 is advantageously argon and the pre-treatment gas fed via the pipe 12 may be especially hydrogen or nitrogen.

The reactive or precursor gas fed via the feed pipe 13 is a single organosilicon compound with a silicon tetrahedral environment. This compound is preferably tetramethylsilane Si(CH₃)₄ (usually denoted by the abbreviation TMS). It is also possible to use tetraethylsilane Si(C₂H₅)₄ (usually denoted by the abbreviation TES) or any other derivative of TMS or TES obtained by substituting one or two ethyl or methyl groups, respectively, with for example hydrogen or chlorine.

It should be noted that the injection pipe 8 may be replaced with any other injection means, such as a system in the form of a ring or grid comprising several injection nozzles, especially if the substrate to be coated is relatively large. However, this other injection means remains in the second region of the treatment chamber 3 defined above and must not obstruct the discharge in which the substrate S is placed.

Moreover, when the substrate to be coated is relatively large, it may also be necessary for there to be relative movement between the reactive gas injection system, such as the injection pipe 8, and the substrate holder 9. For this purpose, the mechanism supporting the substrate holder 9 may have a more complex shape than that illustrated schematically in Figure 2 and may incorporate, for example, at least one motor for moving the substrate holder 9 translationally and/or rotationally. Such arrangements are well known to those skilled in the art and will therefore not be described in further detail.

As soon as the substrate or substrates S are positioned on the substrate holder 9 in the reactor 1, vacuum is created, using the two-stage pumping unit for the primary vacuum followed by the second pumping unit for the secondary vacuum.

After positioning the specimens, a deposition procedure described in Table 1 below is applied.

**Table 1**

| STEPS | OPERATING CONDITIONS |
|---|---|
| Etching | - Regulate the working pressure |
| | - Inject the etching gases |
| | - Turn the microwave and low-frequency generators on |
| | - Heat the activated substrate |
| Intermediate layer formation | - Regulate the gas for producing the intermediate layer: nitriding |
| Nitriding | - Shut off etching gases |
| | - Inject the nitriding gases |
| | - Apply the bias for nitriding |
| Multilayer deposition preparation | - Adjust the gas for depositing the multilayer coatings |
| Periodic multilayer deposition: 10 periods | 1^{st} layer of period 1: |
| | - apply deposition power and bias 1 |
| | - inject deposition gas 1 |
| | 2^{nd} layer of period 1: |
| | - apply deposition power and bias 2 |
| | - inject deposition gas 2 |
| | 1^{st} layer of period 2: |
| | - apply deposition power and bias 1 |
| | - inject deposition gas 1 |
| | 2^{nd} layer of period 2: |
| | - apply deposition power and bias 2 |
| | - inject deposition gas 2 |
| | ...... |
| | 1^{st} layer of period 10: |
| | - apply deposition power and bias 1 |
| | - inject deposition gas 1 |
| | 2^{nd} layer of period 10: |
| | - apply deposition power and bias 2 |
| | - inject deposition gas 2 |
| Surface layer deposition preparation | - Adjust the gas for producing the surface coating |
| Deposition of the surface layer | - Apply deposition power and bias for the functional surface |
| | - Inject the gases |
| Cooling phase | - Turn off the microwave and low-frequency generators |
| | - Stop injecting the gases |
| | - Stop heating the substrate |

### Example

The device described above by means of Figure 2 was used to manufacture a component that includes a multilayer structure according to the invention. To do this, the deposition procedure as defined in Table 1 above was applied so as to treat the surface of a substrate made of a TA6V titanium alloy. The particular temperature, pressure, gas flow rate and voltage conditions used are given in Table 2 below.

**Table 2**

| Step | Operating conditions | Objective |
|---|---|---|
| Etching | P = 0.1 torr Flow (Ar)1 = 7% Vdc = -100 V Power = 500 W | To regulate the working pressure To ignite the Ar plasma To bias |
| | Heating: 540°C | To reach T = 540°C |
| | Flow (Ar)2 = 7.3% Flow (N2) = 11% | To prepare the nitriding flows to ROOTS |
| | Cut Vdc | To stop the bias |
| Nitriding | Power = 500 W | To inject the Ar/N₂ mixture |
| Nitriding gas purge and deposition line preparation | N2 inlet closed Flow (TMS) = 35% Flow (Ar)2 = 1% | To purge N₂ from the chamber and prepare the flows for the deposition phase To prepare the bias during deposition |
| | Power = 700 W | To reach the deposition power |
| Multilayer + functional layer deposition | LF generator off P = 700 W | To inject the gases into the chamber for depositing a layer with no bias |
| | LF generator on Vdc = -100 V P = 700 W | To inject the gases into the chamber for depositing a layer with bias |
| | ... | ... |
| | LF generator off P = 700 W | To inject the gases into the chamber for depositing a layer with no bias |
| Cooling | Flow (Ar)1 | To extinguish the plasma To shut off the gases To stop heating To cool in argon |

A component was obtained that comprised:
- a plasma-etched TA6V titanium alloy substrate;
- a nitride tie layer;
- a complex multilayer according to the invention comprising 10 periods, each period comprising 2 layers each 140 nm in thickness; and
- a functional surface layer.

The component obtained may be represented by the diagram in Figure 1, in which:
- thickness of the tie layer: d_{TL} = 700 nm;
- thicknesses of the individual layers of the multilayer: d_{A} = 140 nm and d_{B} = 140 nm;
- thickness of the period: A = d_{A} + d_{B} = 140 + 140 = 280 nm;
- number of periods: n = 10, resulting in a total multilayer thickness d_{ML} = nΛ = 10×280 = 2800 nm; and
- thickness of the carbon-based functional surface layer: d_{FSL} = 200 nm.

The composition and the properties of the various layers of the component are given in Tables 3 and 4 below.

**Table 3**

| | Composition | Hydrogen (at%) | Atomic composition | Thickness (nm) | Hardness (GPa) | Young's modulus (GPa) |
|---|---|---|---|---|---|---|
| Tie layer (TL) | Nitrogen | - | N = 54 at% | 700 | 19.1 | 211 |
| Soft a-SiC:H 1^{st} layer (A) of the period | Carbon, Silicon, Hydrogen | 20 | Si/C = 0.59 | 140 | 20.4 | 141 |
| Hard a-SiC:H 2^{nd} layer (B) of the period | Carbon, Silicon, Hydrogen | 20 | Si/C = 0.59 | 140 | 24.1 | 153 |
| Functional surface layer (FSL) | Carbon, Silicon, Hydrogen | 20 | Si/C = 0.60 | 200 | 20.4 | 141 |

The mechanical properties of the specimen obtained above, such as the wear rates and the coefficient of friction, and also the corrosion resistance and the adhesion, were then measured. The results are given in Table 4 below.

**Table 4: properties of the multilayer structure**

| Properties | Tests | | Results |
|---|---|---|---|
| Mechanical | Rotary friction | Friction | µ = 0.06 |
| | | Wear | < 10⁻⁵ mm³.N.m⁻¹ |
| | Reciprocating friction | Friction | µ = 0.15 |
| | | Wear | < 10⁻⁵ mm³.N.m⁻¹ |
| Corrosion | Electrochemical | Dissolution potential | 100 hours |
| Adhesion | Scratch resistance | | Critical threshold load for adhesive failure = 22.5 N |

## Claims

1. Corrosion-resistant thin-film multilayer structure having a low wear rate and a low coefficient of friction, **characterized in that** it comprises:
• 1 to 1000 periods, preferably 1 to 500 periods, one period comprising 2 to 100 layers (A, B) , preferably 2 to 10 layers,
each layer (A, B) in the period consisting of carbon, silicon and hydrogen, and containing 10 to 30 at% hydrogen, the Si/C atomic ratio ranging from 0.3 to 1.5, and
• optionally, a functional surface layer (FSL).

2. Thin-film multilayer structure according to Claim 1, **characterized in that** it has a total thickness of 10 µm or less.

3. Thin-film multilayer structure according to Claim 2, **characterized in that** it has a total thickness ranging from 1 to 6 µm.

4. Thin-film multilayer structure according to any one of the preceding claims, **characterized in that** the thickness (d_{A}, d_{B}) of each layer varies from 5 nm to 5 µm.

5. Thin-film multilayer structure according to any one of the preceding claims, **characterized in that** each layer (A, B) in the period has, independently of one another in a period, a hardness of 1 to 100 GPa and a Young's modulus of 10 to 600 GPa.

6. Thin-film multilayer structure according to any one of the preceding claims, **characterized in that** the functional surface layer (FSL) essentially comprises carbon.

7. Thin-film multilayer structure according to Claim 6, **characterized in that** the functional surface layer (FSL) contains 30 to 100 at% carbon.

8. Thin-film multilayer structure according to Claim 6 or 7, **characterized in that** the functional surface layer (FSL) comprises additional elements chosen from silicon, hydrogen, sulphur, fluorine, titanium and tungsten, in proportions ranging from 0 to 70 at%.

9. Thin-film multilayer structure according to any one of the preceding claims, **characterized in that** the thickness (d_{FSL}) of the functional surface layer is 3 µm or less.

10. Thin-film multilayer structure according to Claim 9, **characterized in that** the thickness (D_{FSL}) of the functional surface layer lies in the range from 1 nm to 2 µm.

11. Corrosion-resistant component having a low wear rate and a low coefficient of friction, **characterized in that** it comprises:
- a metal substrate made of a material that is not impaired when it is heated to a temperature ranging up to 600°C;
- a tie layer interposed between the substrate and the surface coating; and
- a surface coating covering the tie layer, the surface coating being a thin-film multilayer structure according to any one of Claims 1 to 10.

12. Component according to Claim 11, **characterized in that** the metal substrate is made of titanium or one of its alloys, high-speed steel, stainless steel, or a carbide.

13. Component according to Claim 11 or 12, **characterized in that** the tie layer is nitrided, carburized, carbonitrided or silicided.

14. Component according to any one of Claims 11 to 13, **characterized in that** the tie layer has a thickness of 0.1 to 100 µm.

15. Method of depositing a surface coating in the form of a corrosion-resistant thin-film multilayer structure having a low wear rate and a low coefficient of friction on a metal substrate made of a material that is not impaired when it is heated to a temperature below 600°C, by chemical vapour deposition, activated by a microwave plasma and/or by a low-frequency plasma, comprising the following successive steps:
i) installation of the substrate on a support, in a chamber comprising an introduction/extraction zone and an active zone that can contain a plasma of maximum density, this installation step being followed by the following surface treatment steps:
ii) creation of a primary vacuum inside the chamber followed by a secondary vacuum;
iii) etching of the substrate in the active zone by injecting an etching gas in a primary vacuum, creation of a plasma of this gas in a discharge zone and by separately heating the substrate to a regulated temperature between 200°C and 600°C;
iv) formation of a tie layer by injecting a pretreatment gas into the active zone of the chamber, so as to substitute the etching gas plasma with a pre-treatment gas plasma, while continuing to heat the substrate at said regulated temperature;
v) formation of the multilayer structure according to any one of Claims 1 to 10 by injecting a reactive gas into the active zone, this reactive gas comprising a single compound having a tetrahedral silicon environment or a silicon-containing mixture, so as to substitute the pre-treatment gas plasma with a reactive gas, while continuing to heat the substrate at said regulated temperature, the various layers being obtained by modifying the power of the microwave generator and/or the frequency and/or the voltage of the low-frequency generator;
vi) optional deposition of the functional surface layer in the active zone, by injecting another reactive gas, so as to substitute the plasma of the gas for producing the multilayer structure with a plasma of the reactive gas, while continuing to heat at said regulated temperature; and
vii) interruption of the reactive gas injection of step v) or step vi) and cooling of the substrate, after a predetermined injection time corresponding to the desired thickness of the functional surface layer, the primary vacuum created inside the chamber corresponding to a pressure of 0.13 to 133.3 Pa (10⁻³ to 1 torr), preferably 0.13 to 66.7 Pa (10⁻³ to 0.5 torr).

16. Method according to Claim 15, **characterized in that** the pre-treatment gas contains the element nitrogen and/or the element carbon and/or the element hydrogen and/or the element silicon.

17. Method according to Claim 16, **characterized in that** the pre-treatment gas comprises at most about 20% nitrogen and/or methane, mixed with argon.

18. Method according to any one of Claims 15 to 17, **characterized in that** the reactive gas of step v) comprises tetramethylsilane (TMS) or tetraethylsilane (TES) by itself or as a mixture, or else a mixture of precursors of hydrocarbons and/or of silicon-containing compounds.

19. Method according to Claim 18, **characterized in that** the reactive gas also contains hydrogen and/or argon.

## Patentansprüche

1. Korrosionsbeständige mehrschichtige Dünnfilmstruktur mit einer niedrigen Abnutzungsrate und einem niedrigen Reibungskoeffizienten, **dadurch gekennzeichnet, daß** sie folgendes umfaßt:
• 1 bis 1000 Perioden, bevorzugt 1 bis 500 Perioden, wobei eine Periode 2 bis 100 Schichten (A, B), bevorzugt 2 bis 10 Schichten, umfaßt,
wobei jede Schicht (A, B) in der Periode aus Kohlenstoff, Silizium und Wasserstoff besteht und 10 bis 30 Atomprozent Wasserstoff enthält, wobei das Si/C-Atomverhältnis im Bereich zwischen 0,3 und 1,5 liegt, und
• optional eine funktionelle Oberflächenschicht (FSL).

2. Mehrschichtige Dünnfilmstruktur nach Anspruch 1, **dadurch gekennzeichnet, daß** sie eine Gesamtdicke von 10 µm oder weniger aufweist.

3. Mehrschichtige Dünnfilmstruktur nach Anspruch 2, **dadurch gekennzeichnet, daß** sie eine Gesamtdicke im Bereich von 1 bis 6 µm aufweist.

4. Mehrschichtige Dünnfilmstruktur nach einem der vorhergehenden Ansprüche, **dadurch gekennzeichnet, daß** die Dicke (d_{A}, d_{B}) jeder Schicht zwischen 5 nm und 5 µm variiert.

5. Mehrschichtige Dünnfilmstruktur nach einem der vorhergehenden Ansprüche, **dadurch gekennzeichnet, daß** jede Schicht (A, B) in der Periode, unabhängig voneinander in einer Periode, eine Härte von 1 bis 100 GPa und ein Elastizitätsmodul von 10 bis 600 GPa aufweist.

6. Mehrschichtige Dünnfilmstruktur nach einem der vorhergehenden Ansprüche, **dadurch gekennzeichnet, daß** die funktionelle Oberflächenschicht (FSL) im Wesentlichen Kohlenstoff umfaßt.

7. Mehrschichtige Dünnfilmstruktur nach Anspruch 6, **dadurch gekennzeichnet, daß** die funktionelle Oberflächenschicht (FSL) 30 bis 100 Atomprozent Kohlenstoff enthält.

8. Mehrschichtige Dünnfilmstruktur nach Anspruch 6 oder 7, **dadurch gekennzeichnet, daß** die funktionelle Oberflächenschicht (FSL) zusätzliche Elemente umfaßt, ausgewählt unter Silizium, Wasserstoff, Schwefel, Fluor, Titan und Wolfram in Anteilen im Bereich von 0 bis 70 Atomprozent.

9. Mehrschichtige Dünnfilmstruktur nach einem der vorhergehenden Ansprüche, **dadurch gekennzeichnet, daß** die Dicke (D_{FSL}) der funktionellen Oberflächenschicht 3 µm oder weniger beträgt.

10. Mehrschichtige Dünnfilmstruktur nach Anspruch 9, **dadurch gekennzeichnet, daß** die Dicke (D_{FSL}) der funktionellen Oberflächenschicht im Bereich von 1 nm bis 2 µm liegt.

11. Korrosionsbeständige Komponente mit einer niedrigen Abnutzungsrate und einem niedrigen Reibungskoeffizienten, **dadurch gekennzeichnet, daß** sie folgendes umfaßt:
- ein Metallsubstrat, das aus einem Material hergestellt ist, das nicht beeinträchtigt wird, wenn es auf eine Temperatur im Bereich von bis zu 600°C erhitzt wird;
- eine Verbindungsschicht, die zwischen dem Substrat und der Oberflächenbeschichtung angeordnet ist; und
- eine Oberflächenbeschichtung, die die Verbindungsschicht bedeckt, wobei die Oberflächenbeschichtung eine mehrschichtige Dünnfilmstruktur nach einem der Ansprüche 1 bis 10 ist.

12. Komponente nach Anspruch 11, **dadurch gekennzeichnet, daß** das Metallsubstrat aus Titan oder einer seiner Legierungen, Schnellstahl, rostfreiem Stahl oder einem Carbid hergestellt ist.

13. Komponente nach Anspruch 11 oder 12, **dadurch gekennzeichnet, daß** die Verbindungsschicht nitriert, carburiert, carbonitriert oder siliciert ist.

14. Komponente nach einem der Ansprüche 11 bis 13, **dadurch gekennzeichnet, daß** die Verbindungsschicht eine Dicke von 0,1 bis 100 µm aufweist.

15. Verfahren zum Abscheiden einer Oberflächenbeschichtung in der Form einer korrosionsbeständigen mehrschichtigen Dünnfilmstruktur mit einer niedrigen Abnutzungsrate und einem niedrigen Reibungskoeffizienten auf einem Metallsubstrat, das aus einem Material hergestellt ist, das nicht beeinträchtigt wird, wenn es auf eine Temperatur auf unter 600°C erhitzt wird, und zwar durch chemische Abscheidung aus der Dampfphase, aktiviert durch ein Mikrowellenplasma und/oder ein Niederfrequenzplasma, umfassend die folgenden aufeinanderfolgenden Schritte:
i)Installation des Substrats auf einem Träger, in einer Kammer, die eine Einleitungs-/Extraktionszone und eine aktive Zone, die ein Plasma maximaler Dichte enthalten kann, umfaßt, wobei auf diesen Installationsschritt die folgenden Oberflächenbehandlungsschritte folgen:
ii) Erzeugen eines Primärvakuums innerhalb der Kammer gefolgt von einem Sekundärvakuum;
iii) Ätzen des Substrats in der aktiven Zone durch Injizieren eines Ätzgases in einem Primärvakuum, Erzeugung eines Plasmas dieses Gases in einer Entladungszone und durch separates Erhitzen des Substrats auf eine geregelte Temperatur zwischen 200°C und 600°C;
iv) Ausbilden einer Verbindungsschicht durch Injizieren eines Vorbehandlungsgases in die aktive Zone der Kammer, um das Ätzgasplasma mit einem Vorbehandlungsgasplasma zu substituieren, während das Substrat weiterhin auf die geregelte Temperatur erhitzt wird;
v) Ausbilden der mehrschichtigen Struktur nach einem der Ansprüche 1 bis 10 durch Injizieren eines reaktiven Gases in die aktive Zone, wobei dieses reaktive Gas eine siliziumhaltige einzelne Verbindung mit einer tetraedrischen Umgebung oder eine siliziumhaltige Mischung umfaßt, um das Vorbehandlungsgasplasma mit einem reaktiven Gas zu substituieren, während das Substrat weiterhin auf der geregelten Temperatur erhitzt wird, wobei die verschiedenen Schichten durch Modifizieren der Leistung des Mikrowellengenerators und/oder der Frequenz und/oder der Spannung des Niederfrequenzgenerators erhalten werden;
vi) optionale Abscheidung der funktionellen Oberflächenschicht in der aktiven Zone durch Injizieren eines weiteren reaktiven Gases, um das Plasma des Gases für das Herstellen der mehrschichtigen Struktur mit einem Plasma des reaktiven Gases zu substituieren, während weiter bei der geregelten Temperatur erhitzt wird; und
vii) Unterberechung der Injektion von reaktiven Gas von Schritt v) oder Schritt vi) und Kühlen des Substrats nach einer vorbestimmten Injektionszeit entsprechend der gewünschten Dicke der funktionellen Oberflächenschicht,
wobei das innerhalb der Kammer erzeugte primäre Vakuum einem Druck von 0,13 bis 133,3 Pa (10⁻³ bis 1 Torr), bevorzugt 0,13 bis 66,7 Pa (10⁻³ bis 0,5 Torr), entspricht.

16. Verfahren nach Anspruch 15, **dadurch gekennzeichnet, daß** das Vorbehandlungsgas das Element Stickstoff und/oder das Element Kohlenstoff und/oder das Element Wasserstoff und/oder das Element Silizium enthält.

17. Verfahren nach Anspruch 16, **dadurch gekennzeichnet, daß** das Vorbehandlungsgas höchstens etwa 20% Stickstoff und/oder Methan, gemischt mit Argon, umfaßt.

18. Verfahren nach einem der Ansprüche 15 bis 17, **dadurch gekennzeichnet, daß** das reaktive Gas von Schritt v) Tetramethylsilan (TMS) oder Tetraethylsilan (TES) alleine oder als eine Mischung oder ansonsten eine Mischung von Vorläufern von Kohlenwasserstoffen und/oder siliziumhaltigen Verbindungen umfaßt.

19. Verfahren nach Anspruch 18, **dadurch gekennzeichnet, daß** das reaktive Gas auch Wasserstoff und/oder Argon enthält.

## Revendications

1. Structure multicouche de type film mince, résistante à la corrosion, dotée d'un faible taux d'usure et d'un faible coefficient de frottement, **caractérisée en ce qu'**elle comprend :
• 1 à 1000 périodes et de préférence 1 à 500 périodes, une période comportant 2 à 100 couches (A, B) et de préférence 2 à 10 couches, et chaque couche (A, B) d'une période étant constituée de carbone, de silicium et d'hydrogène et contenant 10 à 30 % en atomes d'hydrogène, le rapport atomique Si/C valant de 0,3 à 1,5 ;
• et en option, une couche de surface fonctionnelle (CSF).

2. Structure multicouche de type film mince, selon la revendication 1, **caractérisée en ce que** son épaisseur totale est inférieure ou égale à 10 µm.

3. Structure multicouche de type film mince, selon la revendication 2, **caractérisée en ce que** son épaisseur totale vaut de 1 à 6 µm.

4. Structure multicouche de type film mince, selon l'une quelconque des revendications précédentes, **caractérisée en ce que** l'épaisseur (d_{A}, d_{B}) de chaque couche vaut de 5 nm à 5 µm.

5. Structure multicouche de type film mince, selon l'une quelconque des revendications précédentes, **caractérisée en ce que** chaque couche (A, B) d'une période présente, indépendamment des autres couches de la période, une dureté de 1 à 100 GPa et un module d'Young de 10 à 600 GPa.

6. Structure multicouche de type film mince, selon l'une quelconque des revendications précédentes, **caractérisée en ce que** la couche de surface fonctionnelle (CSF) comprend essentiellement du carbone.

7. Structure multicouche de type film mince, selon la revendication 6, **caractérisée en ce que** la couche de surface fonctionnelle (CSF) contient du carbone en une proportion de 30 à 100 % en atomes.

8. Structure multicouche de type film mince, selon la revendication 6 ou 7, **caractérisée en ce que** la couche de surface fonctionnelle (CSF) comprend des éléments supplémentaires choisis parmi du silicium, de l'hydrogène, du soufre, du fluor, du titane et du tungstène, en des proportions valant de 0 à 70 % en atomes.

9. Structure multicouche de type film mince, selon l'une quelconque des revendications précédentes, **caractérisée en ce que** l'épaisseur d_{CSF} de la couche de surface fonctionnelle est inférieure ou égale à 3 µm.

10. Structure multicouche de type film mince, selon la revendication 9, **caractérisée en ce que** l'épaisseur d_{CSF} de la couche de surface fonctionnelle vaut de 1 nm à 2 µm.

11. Composant résistant à la corrosion, doté d'un faible taux d'usure et d'un faible coefficient de frottement, **caractérisé en ce qu'**il comprend :
- un substrat métallique fait d'un matériau qui ne se dégrade pas quand il est chauffé à une température valant jusqu'à 600 °C ;
- une couche d'accroche disposée entre le substrat et le revêtement de surface ;
- et un revêtement de surface recouvrant la couche d'accroche, lequel revêtement de surface est une structure multicouche de type film mince, selon l'une quelconque des revendications 1 à 10.

12. Composant selon la revendication 11, **caractérisé en ce que** le substrat métallique est en titane ou en un alliage de titane, en acier rapide, en acier inoxydable ou en un carbure.

13. Composant selon la revendication 11 ou 12, **caractérisé en ce que** la couche d'accroche est nitrurée, carburée, carbonitrurée ou siliciurée.

14. Composant selon l'une quelconque des revendications 11 à 13, **caractérisé en ce que** la couche d'accroche est épaisse de 0,1 à 100 µm.

15. Procédé de dépôt d'un revêtement de surface, sous la forme d'une structure multicouche de type film mince, résistante à la corrosion, dotée d'un faible taux d'usure et d'un faible coefficient de frottement, sur un substrat métallique fait d'un matériau qui ne se dégrade pas quand il est chauffé à une température inférieure à 600 °C, par dépôt chimique à partir d'une phase vapeur, activé par plasma micro-ondes ou par plasma basse fréquence, lequel procédé comporte les étapes successives suivantes :
i) installer le substrat sur un support, dans une chambre comprenant une zone d'introduction/extraction et une zone active qui peut contenir un plasma de densité maximale ;
laquelle étape d'installation est suivie des étapes suivantes de traitement de surface :
ii) établir à l'intérieur de la chambre un vide primaire, puis un vide secondaire ;
iii) décaper le substrat dans la zone active, en injectant un gaz de décapage dans le vide primaire, en créant un plasma de ce gaz dans une zone à décharge, et en chauffant séparément le substrat à une température régulée située entre 200 et 600 °C ;
iv) former une couche d'accroche, en injectant un gaz de prétraitement dans la zone active de la chambre de manière à remplacer le plasma de gaz de décapage par un plasma de gaz de prétraitement, tout en conti-nuant à chauffer le substrat à ladite température régulée ;
v) former une structure multicouche selon l'une quelconque des revendications 1 à 10, en injectant dans la zone active un gaz réactif qui comprend un composé unique comportant du silicium en environnement tétraédrique ou un mélange comportant du silicium, de façon à remplacer le plasma de gaz de prétraitement par un gaz réactif, tout en continuant à chauffer le substrat à ladite température régulée, les diverses couches étant obtenues par modification de la puissance du générateur micro-ondes et/ou de la fréquence du générateur basse fréquence et/ou de la tension de ce dernier ;
vi) en option, déposer la couche de surface fonctionnelle dans la zone active, en injectant un autre gaz réactif de manière à remplacer le plasma de gaz servant à produire la structure multicouche par un plasma de cet autre gaz réactif, tout en continuant à chauffer le substrat à ladite température régulée ;
vii) et mettre fin à l'injection de gaz réactif de l'étape (v) ou (vi) et faire refroidir le substrat, après une durée d'injection prédéterminée, correspondant à l'épaisseur voulue pour la couche de surface fonctionnelle ;
étant entendu que le vide primaire établi à l'intérieur de la chambre correspond à une pression de 0,13 à 133,3 Pa (10⁻³ à 1 torr) et de préférence de 0,13 à 66,7 Pa (10⁻³ à 0,5 torr).

16. Procédé selon la revendication 15, **caractérisé en ce que** le gaz de prétraitement contient de l'élément azote et/ou de l'élément carbone et/ou de l'élément hydrogène et/ou de l'élément silicium.

17. Procédé selon la revendication 16, **caractérisé en ce que** le gaz de prétraitement comprend au plus environ 20 % d'azote et/ou de méthane, mélangé(s) avec de l'argon.

18. Procédé selon l'une quelconque des revendications 15 à 17, **caractérisé en ce que** le gaz réactif de l'étape (v) comprend du tétraméthylsilane (TMS) ou du tétraéthylsilane (TES), seul ou au sein d'un mélange, ou bien un mélange de précurseurs d'hydrocarbures et/ou de composés contenant du silicium.

19. Procédé selon la revendication 18, **caractérisé en ce que** le gaz réactif contient aussi de l'hydrogène et/ou de l'argon.
